# EUROPEAN PATENT APPLICATION

(11) **EP 4 074 569 A1**
(43) Date of publication of application: **19.10.2022**
(21) Application number: 22163857.0
(22) Date of filing: 23.03.2022
(51) Int. Cl.: B60W 60/00, G06F 30/15, G06F 30/20, G01M 17/007

(54) **METHOD FOR DETERMINING AUTOMATIC DRIVING FEATURE, APPARATUS, DEVICE, MEDIUM AND PROGRAM PRODUCT**

(30) Priority: 16.04.2021 CN 202110414473
(71) Applicant: Apollo Intelligent Connectivity (Beijing) Technology Co., Ltd., Beijing 100176 (CN)
(72) Inventor: CHEN, Manni, Beijing, 100176 (CN); ZHANG, Binglin, Beijing, 100176 (CN)
(74) Representative: Studio Torta S.p.A.

(57) **Abstract**

The present application discloses a method for determining an automatic driving feature, an apparatus, a device, a medium and a program product, and relates to automatic driving technology in the field of artificial intelligence. A specific solution is: acquiring scenario information of a plurality of driving scenarios and driving behavior information of an automatic driving system in each of the driving scenarios, where the driving behavior information includes a decision made by the automatic driving system and an execution result corresponding to the decision; determining an automatic driving feature of the automatic driving system according to the scenario information of the plurality of driving scenarios and respective driving behavior information. The automatic driving feature determined through the above process can represent a characteristic of an automatic driving strategy adopted by the automatic driving system. Therefore, a map can provide the automatic driving system with more accurate decision pre-judgment information according to the automatic driving feature, improving the safety of automatic driving.

## Description

### TECHNICAL FIELD

The present application relates to automatic driving technology in the field of artificial intelligence, and in particular to a method for determining an automatic driving feature, an apparatus, a device, a medium and a program product.

### BACKGROUND

In an automatic driving scenario, a map can provide decision pre-judgment information for an automatic driving system based on information such as a navigation route and road condition. For example, the map can provide, at a suitable distance in advance, the automatic driving system with a signal of preparing for a lane change.

Different automatic driving systems use different driving strategies. For example, in a lane change scenario, some automatic driving systems adopt more radical strategies and can complete a lane change operation quickly; other automatic driving systems adopt more conservative strategies, even if there is a vehicle driving slowly behind in a target lane, they will wait for the vehicle behind to pass before completing the lane change. If the map provides the same decision pre-judgment information for different automatic driving systems, it may cause a potential driving hazard. Therefore, the map needs to know respective automatic driving features of different automatic driving systems, and provide different automatic driving systems with different decision pre-judgment information according to the automatic driving features, thereby ensuring the safety of automatic driving.

However, how to determine an automatic driving feature of an automatic driving system to guide the map to make decision pre-judgment is a technical problem that needs to be solved urgently.

### SUMMARY

The present application provides a method for determining an automatic driving feature, an apparatus, a device, a medium and a program product.

According to a first aspect of the present application, a method for determining an automatic driving feature is provided, including:
acquiring scenario information of a plurality of driving scenarios and driving behavior information of an automatic driving system in each of the driving scenarios, where the driving behavior information includes a decision made by the automatic driving system and an execution result corresponding to the decision;
determining an automatic driving feature of the automatic driving system according to the scenario information of the plurality of driving scenarios and respective driving behavior information, where the automatic driving feature is used for a map to provide decision pre-judgment information for the automatic driving system.

According to a second aspect of the present application, an apparatus for determining an automatic driving feature is provided, including:
an acquiring module, configured to acquire scenario information of a plurality of driving scenarios and driving behavior information of an automatic driving system in each of the driving scenarios, where the driving behavior information includes a decision made by the automatic driving system and an execution result corresponding to the decision;
a determining module, configured to determine an automatic driving feature of the automatic driving system according to the scenario information of the plurality of driving scenarios and respective driving behavior information, where the automatic driving feature is used for a map to provide decision pre-judgment information for the automatic driving system.

According to a third aspect of the present application, an electronic device is provided, including:
at least one processor; and
a memory communicatively connected to the at least one processor; where,
the memory stores instructions executable by the at least one processor, and the instructions are executed by the at least one processor to enable the at least one processor to execute the method according to the first aspect.

According to a fourth aspect of the present application, a non-transitory computer-readable storage medium having computer instructions stored thereon is provided, where the computer instructions are used to cause a computer to execute the method according to the first aspect.

According to a fifth aspect of the present application, a computer program product is provided, and the computer program product comprises: a computer program, which is stored in a readable storage medium. At least one processor of an electronic device can read the computer program from the readable storage medium, and the at least one processor executes the computer program to cause the electronic device to execute the method according to the first aspect.

It should be understood that the content described in this section is not intended to identify key or important features of embodiments of the present application, nor is it intended to limit the scope of the present application. Other features of the present application will be easily understood through the following description.

### BRIEF DESCRIPTION OF DRAWINGS

The drawings are used to better understand the solutions, and do not constitute a limitation on the present application, where:
FIG. 1 is a schematic diagram of an automatic driving controlling process provided in an embodiment of the present application;
FIG. 2 is a schematic diagram of an application scenario provided in an embodiment of the present application;
FIG. 3 is a schematic flowchart of a method for determining an automatic driving feature provided in an embodiment of the present application;
FIG. 4 is a schematic flowchart of another method for determining an automatic driving feature provided in an embodiment of the present application;
FIG. 5 is a schematic diagram of a process of determining an automatic driving feature provided in an embodiment of the present application;
FIG. 6 is a schematic diagram of another process of determining an automatic driving feature provided in an embodiment of the present application;
FIG. 7 is a schematic structural diagram of an apparatus for determining an automatic driving feature provided in an embodiment of the present application;
FIG. 8 is a schematic structural diagram of an electronic device provided in an embodiment of the present application.

### DESCRIPTION OF EMBODIMENTS

Exemplary embodiments of the present application are described below with reference to the accompanying drawings, where various details of the embodiments of the present application are included to facilitate understanding, and should be considered as merely exemplary. Therefore, those of ordinary skill in the art should recognize that various changes and modifications can be made to the embodiments described herein without departing from the scope of the present application. Similarly, for clarity and conciseness, descriptions of well-known functions and structures are omitted in the following description.

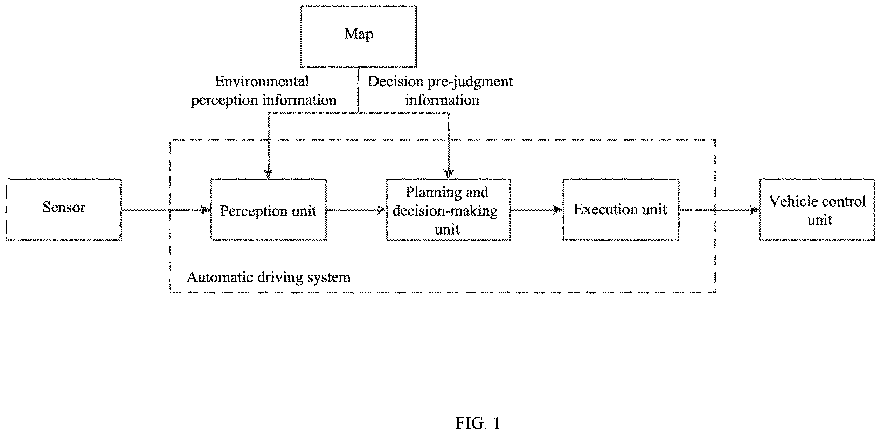

With the development of automatic driving technology, an automatic driving system of a vehicle gradually establishes a deeper connection with a map. The map can provide the automatic driving system with environmental perception auxiliary information, decision pre-judgment information, etc. To make it easier to understand, description will be given below combined with FIG. 1.

FIG. 1 is a schematic diagram of an automatic driving controlling process provided in an embodiment of the present application. As shown in FIG. 1, an automatic driving system includes a perception unit, a planning and decision-making unit, and a control unit. A variety of sensors are provided in a vehicle, including but not limited to: radar, cameras, infrared sensors, etc. The perception unit is configured to perceive sensing data collected by the sensors to obtain obstacle information and road environment information around the vehicle. The planning and decision-making unit is configured to analyze the perceived obstacle information and road environment information, plan a travelling route, and generate decision information during travelling. The control unit is configured to convert the decision information into a control signal such as braking, accelerating or steering, and output the control signal to a vehicle control unit of the vehicle to control the vehicle to follow the planned route.

Since the map (especially a high-precision map) includes detailed lane lines, traffic signs, traffic lights, lane height limit, lane speed limit and other road information, and further includes some road attribute information related to traffic safety, such as GPS signal disappearance areas, road construction state, etc. Therefore, in the automatic driving process of the vehicle, the map can provide the automatic driving system with some automatic driving assistance information.

As shown in FIG. 1, in a perception stage, the map can provide the automatic driving system with environmental perception information. Exemplarily, the map can notify the current location of the vehicle, the lane where the vehicle is located, the speed limit and the height limit of the current lane, and other information. Exemplarily, the map can also extend sensing ranges of the sensors, and notify the vehicle of road information and traffic condition information in front of the vehicle in advance. Exemplarily, a sensor may experience a decrease in perception performance under complex road conditions or severe weather conditions, and the map can provide environmental perception information in time as assistance and supplement to the sensor.

Continue to refer to FIG. 1, in a planning and decision-making stage, the map can also provide the automatic driving system with decision pre-judgment information to help the automatic driving system make a reasonable plan and decision. Exemplarily, when there is a low-speed limit in front of the vehicle, a signal of preparing to decelerate is provided to the automatic driving system at an appropriate distance in advance. When the vehicle needs to make a lane change, a signal of preparing to make a lane change is provided to the automatic driving system at an appropriate distance in advance.

However, different automatic driving systems use different driving strategies. For example, in a lane change scenario, some automatic driving systems adopt more radical strategies and can complete a lane change operation quickly; other automatic driving systems adopt more conservative strategies, even if there is a vehicle driving slowly behind in a target lane, they will wait for the vehicle behind to pass before completing the lane change. In this way, the difference in automatic driving strategies will cause the map unable to provide the automatic driving system with optimal decision pre-judgment information. If the map provides the same decision pre-judgment information for different automatic driving systems, for example, if the map provides, at the same distance in advance in a lane change scenario, different automatic driving systems with signals of preparing to make a lane change, it may lead to a potential driving hazard.

Therefore, the map needs to acquire respective automatic driving features of different automatic driving systems, and provide different automatic driving systems with different decision pre-judgment information according to the automatic driving features, thereby ensuring the safety of automatic driving.

In some related technologies, the automatic driving system can be classified into levels, and differences in automatic driving capabilities can be indicated through different levels. Exemplarily, the automatic driving system can be classified into levels L0-L5 according to the degree of control of the vehicle by the automatic driving system. L0 is manual driving by a driver. L1 is assisted driving. The automatic driving system can sometimes help the driver to complete certain driving tasks, and can only help to complete one driving operation. The driver needs to monitor the driving environment and be prepared to take over at any time. L2 is partial automatic driving. The automatic driving system has multiple functions and can control the speed and keep the lane at the same time. The driver needs to monitor the driving environment and be prepared to take over at any time. L3 is conditional automatic driving. When conditions permit, the vehicle can complete all driving operations and has a function of reminding the driver. The driver does not need to monitor the driving environment and can be distracted, but the driver cannot sleep and needs to be able to take over the vehicle at any time, so as to deal with situations which may arise and which cannot be handled by artificial intelligence, at any time. L4 is high automatic driving, which realizes fully automatic driving under certain scenarios with or without the driver. L5 is fully automatic driving, which can realize automatic driving in any scenario. However, according to the above classification manner, the different levels represent degrees of control of the vehicle by the automatic driving system, or levels of automatic driving ability, and cannot represent the difference between automatic driving strategies adopted by the automatic driving system. Therefore, the above levels cannot guide the map to output accurate decision pre-judgment information to the automatic driving system.

It can be seen that how to determine an automatic driving feature of the automatic driving system to guide the map to output accurate decision pre-judgment information to the automatic driving system is a technical problem that needs to be solved urgently.

To this end, the present application provides a method for determining an automatic driving feature, an apparatus, a device, a medium and a program product, which are applied to the automatic driving technology in the field of artificial intelligence.

In embodiments of the present application, an automatic driving feature represents a characteristic of an automatic driving strategy adopted by an automatic driving system, or a decision characteristic of the automatic driving system, which can be used to guide a map to provide the automatic driving system with better decision pre-judgment information, thereby ensuring the safety of automatic driving.

It should be noted that, the map in the embodiments of the present application may be any of the following: a high-definition map, a normal map, an online map, an offline map, a cloud map, a map for auto, etc.

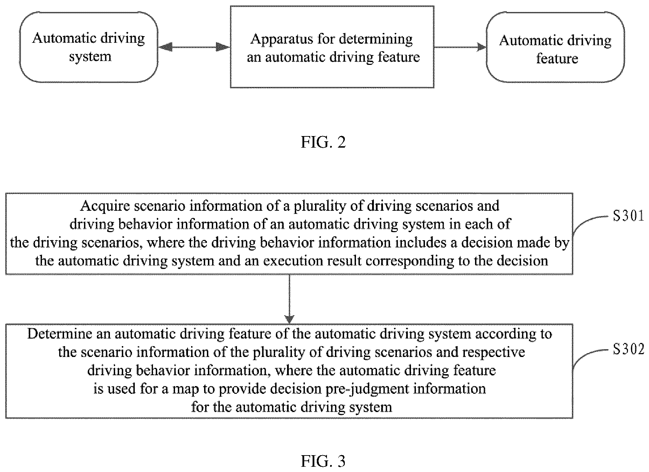

FIG. 2 is a schematic diagram of an application scenario provided in an embodiment of the present application. As shown in FIG. 2, the application scenario includes an automatic driving system and an apparatus for determining an automatic driving feature. The apparatus for determining an automatic driving feature can be used to implement a method for determining an automatic driving feature provided in the present application. The apparatus for determining an automatic driving feature analyzes to obtain an automatic driving feature of the automatic driving system through interaction with the automatic driving system. The automatic driving feature can be used to guide a map to provide the automatic driving system with more accurate decision pre-judgment information.

The apparatus for determining an automatic driving feature may be in the form of software and/or hardware. The apparatus for determining an automatic driving feature may include a plurality of units. These units may be arranged in an integrated manner, for example, may be integrated in one electronic device. These units may also be arranged separately, for example, may be arranged in different electronic devices. The above-mentioned electronic device may be a server, a computer, a terminal device, and so on.

In the technical solutions of the present application, the apparatus for determining an automatic driving feature can acquire scenario information of at least one driving scenario and driving behavior information of an automatic driving system in each driving scenario, where the driving behavior information includes a decision made by the automatic driving system and an execution result corresponding to the decision; further, the apparatus for determining an automatic driving feature determines an automatic driving feature of the automatic driving system according to the scenario information of the at least one driving scenario and the respective driving behavior information. The automatic driving feature determined through the above process can represent a characteristic of an automatic driving strategy adopted by the automatic driving system. Therefore, a map can provide the automatic driving system with more accurate decision pre-judgment information according to the automatic driving feature, so as to improve the safety of automatic driving.

The technical solutions of the present application will be described in detail below in conjunction with several specific embodiments. The following embodiments can be combined with each other, and the same or similar content may not be repeated in some embodiments.

FIG. 3 is a schematic flowchart of a method for determining an automatic driving feature provided in an embodiment of the present application. The method of this embodiment may be executed by the apparatus for determining an automatic driving feature in FIG. 2. The method of this embodiment can be used to determine the automatic driving feature of the automatic driving system shown in FIG. 2.

As shown in FIG. 3, the method of this embodiment includes the following steps.

S301: acquire scenario information of a plurality of driving scenarios and driving behavior information of an automatic driving system in each of the driving scenarios, where the driving behavior information includes a decision made by the automatic driving system and an execution result corresponding to the decision.

The driving scenario in this embodiment includes but is not limited to: a straight driving scenario, a turning scenario, a giving way scenario, a lane change scenario, a parking scenario, an accelerating scenario, a decelerating scenario, etc.

The scenario information of each driving scenario is information used to describe the driving scenario, including but not limited to: road information, travelling state information of a host vehicle, obstacle state information and others in the driving scenario. The scenario information can be collected by a sensor and/or provided by a map.

The scenario information of each driving scenario is inputted into the automatic driving system, and the automatic driving system can obtain the driving behavior information in each driving scenario according to the scenario information of each driving scenario. The driving behavior information in this embodiment includes the decision made by the automatic driving system and the execution result corresponding to the decision.

In some scenarios, the method of this embodiment may adopt an online automatic driving system. Specifically, the automatic driving system is deployed in a vehicle, and the vehicle drives automatically in a real driving scenario. In this scenario, scenario information of this driving scenario can be acquired according to sensing data collected by a vehicle-mounted sensor. Driving behavior information of the automatic driving system in the driving scenario can be determined according to the actual driving situation of the vehicle.

In other scenarios, the solution of this embodiment may also adopt an offline automatic driving system. In this scenario, scenario information of the driving scenario can be generated by simulation and inputted into the automatic driving system, and driving behavior information in the driving scenario is determined according to output data of the automatic driving system.

S302: determine an automatic driving feature of the automatic driving system according to the scenario information of the plurality of driving scenarios and respective driving behavior information, where the automatic driving feature is configured for a map to provide the automatic driving system with decision pre-judgment information.

The automatic driving feature in this embodiment is used to represent a characteristic of an automatic driving strategy adopted by the automatic driving system, or to represent a decision characteristic of the automatic driving system.

Optionally, the automatic driving feature can include at least one of the following: a radicalness degree of a decision, a success rate of decision execution, and similarity between a decision execution process and a manual driving process.

The radicalness degree of a decision indicates a more radical degree or a more conservative degree of a decision made by the automatic driving system. For example, in a lane change scenario, if the automatic driving system makes a more radical decision, its representation is to complete a lane change operation quickly; if the automatic driving system makes a more conservative decision, its representation is to not make a lane change even when a vehicle behind travels slowly, and to make the lane change only after the vehicle behind passes.

The success rate of decision execution indicates a probability or proportion of a decision made by the automatic driving system being capable of being successfully executed. Exemplarily, since some decisions need to be completed within specified time, if they are not completed within execution time, it is considered that the execution of the decisions fails. For example, for a more conservative automatic driving system, if the map provides the automatic driving system with decision pre-judgment information relatively late, it may cause the execution of a decision to fail.

The similarity between a decision execution process and a manual driving process indicates whether a decision execution process conforms to a manual driving habit. For example, if it is not suitable for overtaking or accelerating in some scenarios according to a manual driving habit, but the automatic driving system makes a decision of overtaking or accelerating, the similarity between the decision execution process and the manual driving habit is considered to be relatively low.

Since the driving behavior information includes the decision made by the automatic driving system and the execution result of the decision, it is possible to analyze and obtain, according to the scenario information of a plurality of driving scenarios and the respective driving behavior information, the automatic driving feature that can represent the decision characteristic of the automatic driving system, such as the radicalness degree of the decision, the success rate of decision execution, and the similarity between the decision execution process and the manual driving process.

In this way, after automatic driving features of the automatic driving system are determined, these automatic driving features can be used to guide the map to provide the automatic driving system with more accurate decision pre-judgment information.

Exemplarily, in a lane change scenario, if the radicalness degree of a decision corresponding to a certain automatic driving system is high (that is, relatively radical), the map can output a lane change signal to the automatic driving system at a shorter distance in advance. If the radicalness degree of a decision corresponding to a certain automatic driving system is low (that is, relatively conservative), the map can output a lane change signal to the automatic driving system at a longer distance in advance.

Exemplarily, if the success rate of decision execution corresponding to a certain automatic driving system is low, the map can output the decision pre-judgment information to the automatic driving system at a longer distance in advance, or adjust a strategy of outputting the decision pre-judgment information to the automatic driving system, to improve the success rate of decision execution of the automatic driving system.

Exemplarily, if the similarity between a decision execution process and a manual driving process corresponding to a certain automatic driving system is low, the map can adjust a strategy of outputting the decision pre-judgment information to the automatic driving system, so that the decision execution process of the automatic driving system is more in line with a human driving habit.

The method for determining an automatic driving feature provided in this embodiment includes: acquiring scenario information of a plurality of driving scenarios and driving behavior information of an automatic driving system in each of the driving scenarios, where the driving behavior information includes a decision made by the automatic driving system and an execution result corresponding to the decision; determining an automatic driving feature of the automatic driving system according to the scenario information of the plurality of driving scenarios and the respective driving behavior information. The automatic driving feature determined through the above process can represent a characteristic of an automatic driving strategy adopted by the automatic driving system. Therefore, a map can provide the automatic driving system with more accurate decision pre-judgment information according to the automatic driving feature, thereby improving the safety of automatic driving.

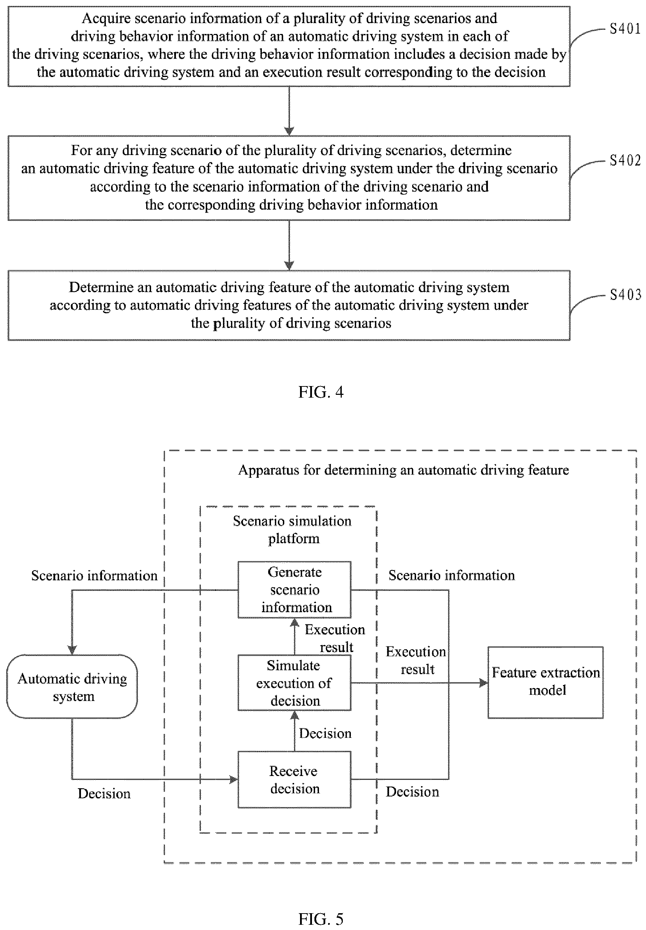

FIG. 4 is a schematic flowchart of another method for determining an automatic driving feature provided in an embodiment of the present application. On the basis of the foregoing embodiment, this embodiment provides a more detailed description of a specific implementation of S302 in the embodiment shown in FIG. 3. As shown in FIG. 4, the method of this embodiment includes the following steps.

S401: acquire scenario information of a plurality of driving scenarios and driving behavior information of an automatic driving system in each of the driving scenarios, where the driving behavior information includes a decision made by the automatic driving system and an execution result corresponding to the decision.

It should be understood that the implementation of S401 is similar to that of S301, and will not be repeated here.

S402: for any driving scenario of the plurality of driving scenarios, determine an automatic driving feature of the automatic driving system under the driving scenario according to the scenario information of the driving scenario and the corresponding driving behavior information.

That is to say, the automatic driving feature of the automatic driving system under each driving scenario is determined respectively. For example, automatic driving features of the automatic driving system under a straight driving scenario, a turning scenario, a giving way scenario, a lane change scenario, a parking scenario, an accelerating scenario and a decelerating scenario are determined respectively.

In a possible implementation, host vehicle state information when the automatic driving system makes a decision can be acquired according to the scenario information of the driving scenario, where the host vehicle state information includes one or more of the following: a speed of a host vehicle, a distance between the host vehicle and an obstacle, a relative speed between the host vehicle and an obstacle. Further, the automatic driving feature of the automatic driving system under the driving scenario is determined according to the host vehicle state information and the driving behavior information. Specifically, a radicalness degree of a decision made by the automatic driving system can be determined according to the host vehicle state information, and it can also be determined whether a decision execution process of the automatic driving system is in line with a human driving habit. The decision execution result of the automatic driving system can be known according to the driving behavior information. When there are multiple sets of data in the same driving scenario, the success rate of decision execution of the automatic driving system under the driving scenario can also be statistically obtained.

For example, by taking a lane change scenario as an example, according to scenario information of the lane change scenario, host vehicle state information when the automatic driving system makes a lane change decision can be acquired, such as: a speed of a host vehicle, a distance between the host vehicle and an obstacle in a same lane, a relative speed between the host vehicle and the obstacle in the same lane, a distance between the host vehicle and an obstacle in a target lane, a relative speed between the host vehicle and the obstacle in the target lane, etc. The radicalness degree of the lane change decision made by the automatic driving system can be determined according to the host vehicle state information, and it can also be determined whether the lane change decision of the automatic driving system is in line with the human driving habit. In addition, since the driving behavior information includes an execution result of the lane change decision, when there are multiple sets of data in the lane change scenario, the success rate of execution of the lane change decision of the automatic driving system can be statistically obtained.

S403: determine an automatic driving feature of the automatic driving system according to automatic driving features of the automatic driving system under the plurality of driving scenarios.

That is to say, the automatic driving features under a plurality of driving scenarios are integrated to obtain the automatic driving feature of the automatic driving system.

In a possible implementation, a weight can be preset for each driving scenario. Weights corresponding to a plurality of driving scenarios are acquired, and a weighting calculation is performed on the automatic driving features under the plurality of driving scenarios according to the weights corresponding to the plurality of driving scenarios, to determine the automatic driving feature of the automatic driving system. In this way, the final determined automatic driving feature can represent characteristics of automatic driving strategies for a plurality of driving scenarios.

In this embodiment, for each driving scenario, the automatic driving feature under the driving scenario is determined, and a weighting calculation is performed on the automatic driving features under a plurality of driving scenarios to obtain an integrated automatic driving feature, so that the automatic driving feature can represent decision characteristics under a variety of driving scenarios, thereby improving the accuracy of the automatic driving feature.

On the basis of the foregoing embodiments, the technical solution of the present application will be described in more detail below in conjunction with a specific embodiment.

FIG. 5 is a schematic diagram of a process of determining an automatic driving feature provided in an embodiment of the present application. In this embodiment, an apparatus for determining an automatic driving feature can include: a scenario simulation platform and a feature extraction model. The scenario simulation platform is used to acquire scenario information of a plurality of driving scenarios and driving behavior information of an automatic driving system in each driving scenario. In other words, the scenario simulation platform can execute S301 in FIG. 3 or execute S401 in FIG. 4. The feature extraction model is used to determine an automatic driving feature of the automatic driving system according to the scenario information of the plurality of driving scenarios and the respective driving behavior information. In other words, the feature extraction model can execute S302 in FIG. 3, or execute S402 and S403 in FIG. 4.

It should be noted that, in this embodiment, the processing process of the scenario simulation platform is similar for each of the plurality of driving scenarios. The description will be given below by only taking the processing process of one driving scenario as an example.

In this embodiment, each driving scenario includes a plurality of consecutive sub-scenarios. Correspondingly, the driving behavior information of the automatic driving system in each driving scenario includes: a decision made by the automatic driving system in each sub-scenario and an execution result corresponding to the decision. The processing process of each driving scenario by the scenario simulation platform will be introduced below in conjunction with FIG. 5.

As shown in FIG. 5, the processing process of the scenario simulation platform includes: acquiring scenario information of a first sub-scenario. The scenario information of the first sub-scenario is inputted into the automatic driving system, to acquire a first decision outputted by the automatic driving system according to the scenario information of the first sub-scenario. The execution of the first decision is simulated to obtain an execution result of the first decision. The scenario information of the first sub-scenario is updated according to the execution result of the first decision, to obtain scenario information of a second sub-scenario.

Then, the scenario information of the second sub-scenario is inputted into the automatic driving system, to acquire a second decision outputted by the automatic driving system according to the scenario information of the second sub-scenario. The execution of the second decision is simulated to obtain an execution result of the second decision. The scenario information of the second sub-scenario is updated according to the execution result of the second decision, to obtain scenario information of a third sub-scenario.

The above process is repeated until the traversal of the plurality of sub-scenarios in the current driving scenario is completed.

In a possible implementation, when scenario information of an i-th sub-scenario is updated to obtain scenario information of an (i+1)-th sub-scenario, the updating of the scenario information of the i-th sub-scenario can also be realized by adjusting an environment variable in the i-th sub-scenario. The environment variable may include a motion parameter of an obstacle, etc., that is, the motion state of the obstacle can be adjusted. The i is an integer greater than or equal to 1.

That is to say, the above updating process can include: determining a target obstacle in the i-th sub-scenario and a motion parameter of the target obstacle, and updating the scenario information of the i-th sub-scenario according to the execution result of the i-th decision and the motion parameter of the target obstacle, to obtain the scenario information of the (i+1)-th sub-scenario.

In this embodiment, after receiving a decision from the automatic driving system, the scenario simulation platform simulates an operation of the vehicle according to the decision to obtain an execution result of the decision, and then updates the scenario information of the current round according to the execution result of the decision to generate a new round of scenario information. By adopting the above process, the generated scenario information is continuous, so that a continuously travelling scenario of the vehicle can be simulated, thereby ensuring the authenticity of the scenario simulation.

In a possible implementation, acquiring the scenario information of the first sub-scenario can include: acquiring sensing data of the first sub-scenario, and performing perceptual processing on the sensing data to obtain the scenario information of the first sub-scenario.

Optionally, the aforementioned sensing data may be generated by simulation. Exemplarily, a scenario simulation tool is used to simulate the first sub-scenario to generate the sensing data of the first sub-scenario.

Optionally, sensing data collected by a vehicle in the first sub-scenario on a real road can also be acquired.

In this implementation, because the scenario information of the sub-scenario is not original sensing data, but obtained by performing perceptual processing on the sensing data, the scenario information of the sub-scenario can be recognized and processed by a planning and decision-making unit of the automatic driving system. Therefore, the scenario information of the sub-scenario can be inputted into the planning and decision-making unit of the automatic driving system, and the decision outputted by the planning and decision-making unit according to the scenario information of the sub-scenario can be acquired.

In this embodiment, by using the scenario information after undergoing the perceptual processing, the scenario information can be directly inputted to the planning and decision-making unit of the automatic driving system without passing through a perception unit of the automatic driving system, which can avoid a perception deviation caused by different perception technologies used by perception units of different automatic driving systems, so as to avoid the difference in perception capabilities of different automatic driving systems from affecting the automatic driving feature. The use of the perceived scenario information can avoid the influence of sensor perception, weather and other factors, and can ensure the accuracy of the determined driving feature.

Continue to refer to FIG. 5, after inputting the scenario information of the current round to the automatic driving system and receiving the decision from the automatic driving system, on the one hand, the scenario simulation platform simulates the execution of the decision to obtain the execution result of the decision, and updates the scenario information of the current round according to the execution result to generate a new round of scenario information; on the other hand, the scenario simulation platform synchronizes the scenario information of the current round, the decision made by the automatic driving system based on the scenario information of the current round, and the execution result of the decision to the feature extraction model, so that the feature extraction model analyzes the above data to obtain the automatic driving feature.

FIG. 5 shows the interaction process between the scenario simulation platform and the automatic driving system as well as the feature extraction model. Through the above-mentioned interaction process, the feature extraction model acquires the scenario information of the plurality of driving scenarios and the driving behavior information of the automatic driving system in each driving scenario.

For each driving scenario, the feature extraction model can record the scenario information, decision and execution result of the decision which correspond to each round of sub-scenarios, and after completing the simulation for the plurality of sub-scenarios of the driving scenario, obtain the automatic driving feature under the driving scenario by analysis according to the collected data of the plurality of sub-scenarios.

After the simulation for the plurality of driving scenarios is completed, a comprehensive analysis is performed on the respective automatic driving features corresponding to the plurality of driving scenarios, to determine an integrated automatic driving feature. This automatic driving feature can represent the decision characteristics of the automatic driving system in the plurality of driving scenarios.

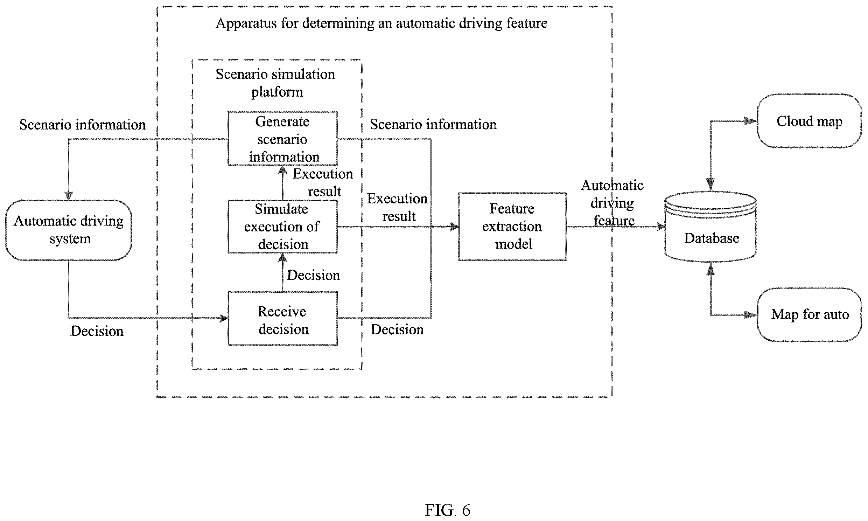

FIG. 6 is a schematic diagram of another process of determining an automatic driving feature provided in an embodiment of the present application. As shown in FIG. 6, on the basis of the embodiment shown in FIG. 5, after the apparatus for determining an automatic driving feature obtains the automatic driving feature, the automatic driving feature can be stored in a database.

The database may be deployed in the apparatus for determining an automatic driving feature, or deployed in other devices. The database may also be a cloud database. The database is used to store automatic driving features of different automatic driving systems.

Optionally, for a certain automatic driving system, the apparatus for determining an automatic driving feature adopts the solution provided in the embodiments of the present application. After the automatic driving feature of the automatic driving system is determined, an identifier, a version number and the automatic driving feature of the automatic driving system can be pushed to the database for storage.

In this way, the map can acquire the automatic driving feature corresponding to the automatic driving system of the vehicle from the database according to the identifier and version number of the automatic driving system. The map may be a cloud map or a map for auto.

For example, when the cloud map needs to provide decision pre-judgment information for a certain automatic driving system, the automatic driving feature corresponding to the automatic driving system can be acquired from the database according to the identifier and version number of the automatic driving system. Further, the cloud map can provide the automatic driving system with accurate decision pre-judgment information according to the automatic driving feature.

For example, when updating is performed, the map for auto can also acquire the automatic driving feature corresponding to the automatic driving system of the vehicle from the database according to the identifier and version number of the automatic driving system. Further, the map for auto can provide the automatic driving system with more accurate decision pre-judgment information according to the automatic driving feature.

The exemplary description will be given below in combination with a specific application scenario.

Take a lane change scenario as an example. For example, take an automatic driving system A and an automatic driving system B as an example. It is assumed that an automatic driving strategy adopted by the automatic driving system A is more radical, while an automatic driving strategy adopted by the automatic driving system B is more conservative. In the lane change scenario, the automatic driving system A will complete a lane change quickly when receiving lane-change pre-judgment information provided by the map. The automatic driving system B will complete a lane change slowly when receiving lane-change pre-judgment information provided by the map, for example, when there is a vehicle behind, will slow down and wait for the vehicle behind to pass before completing the lane change.

In the prior art, since the map cannot acquire the characteristic of the automatic driving strategy adopted by each automatic driving system, the map may provide the lane-change pre-judgment information according to a default automatic driving strategy, for example, output the lane change pre-judgment information to the automatic driving system A and the automatic driving system B at the same distance (for example, 200 meters) in advance. This may lead to a lane change failure or potential driving hazard due to the inaccurate lane-change pre-judgment information provided by the map.

In the embodiments of the present application, the method of any one of the embodiments in FIG. 3 to FIG. 6 can be used to determine the automatic driving features of the automatic driving system A and the automatic driving system B. In this way, the map can recognize that the automatic driving strategy adopted by the automatic driving system A is more radical according to the automatic driving feature of the automatic driving system A. Therefore, the map can output the lane-change pre-judgment information to the automatic driving system A at a shorter distance (for example, 150 meters) in advance. The map can recognize that the automatic driving strategy adopted by the automatic driving system B is more conservative according to the automatic driving feature of the automatic driving system B. Therefore, the map can output the lane-change pre-judgment information to the automatic driving system B at a longer distance (for example, 300 meters) in advance.

It can be seen that in the embodiments of the present application, by determining the automatic driving feature of the automatic driving system, the map can provide the automatic driving system with decision pre-judgment information that meets its strategic feature according to the automatic driving feature, so that the automatic driving system receives more accurate decision pre-judgment information, thereby ensuring the safety of automatic driving.

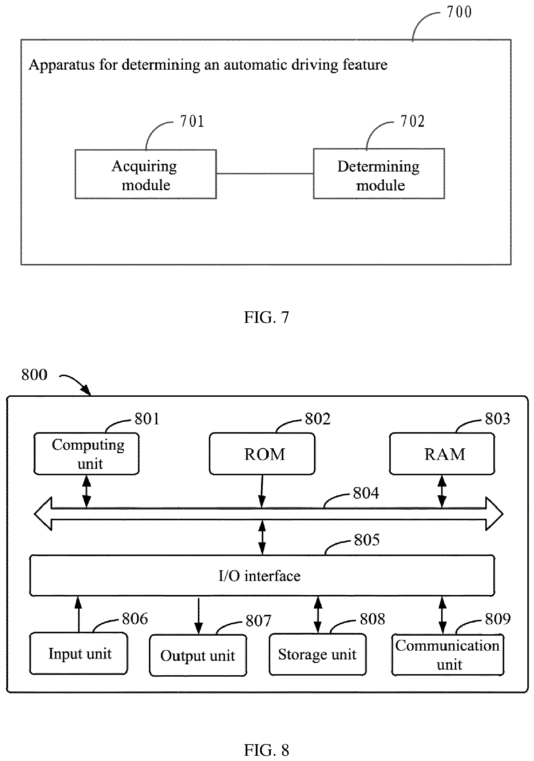

FIG. 7 is a schematic structural diagram of an apparatus for determining an automatic driving feature provided in an embodiment of the present application. The apparatus of this embodiment may be in the form of software and/or hardware. As shown in FIG. 7, the apparatus 700 for determining an automatic driving feature provided in this embodiment can include: an acquiring module 701 and a determining module 702.

The acquiring module 701 is configured to acquire scenario information of a plurality of driving scenarios and driving behavior information of an automatic driving system in each of the driving scenarios, where the driving behavior information includes a decision made by the automatic driving system and an execution result corresponding to the decision.

The determining module 702 is configured to determine an automatic driving feature of the automatic driving system according to the scenario information of the plurality of driving scenarios and respective driving behavior information, where the automatic driving feature is used for a map to provide decision pre-judgment information for the automatic driving system.

In a possible implementation, the determining module 702 includes:
a first determining unit, configured to: for any driving scenario of the plurality of driving scenarios, determine an automatic driving feature of the automatic driving system under the driving scenario according to the scenario information of the driving scenario and the corresponding driving behavior information;
a second determining unit, configured to determine the automatic driving feature of the automatic driving system according to automatic driving features of the automatic driving system under the plurality of driving scenarios.

In a possible implementation, the first determining unit includes:
a first acquiring subunit, configured to acquire, according to the scenario information of the driving scenario, host vehicle state information when the automatic driving system makes the decision, wherein the host vehicle state information comprises at least one of the following: a speed of a host vehicle, a distance between the host vehicle and an obstacle, a relative speed between the host vehicle and the obstacle;
a first determining subunit, configured to determine the automatic driving feature of the automatic driving system under the driving scenario according to the host vehicle state information and the driving behavior information.

In a possible implementation, the second determining unit includes:
a second acquiring subunit, configured to acquire weights corresponding to the plurality of driving scenarios;
a second determining subunit, configured to perform a weighting calculation on the automatic driving features under the plurality of driving scenarios according to the weights corresponding to the plurality of driving scenarios, to determine the automatic driving feature of the automatic driving system.

In a possible implementation, each driving scenario includes a plurality of consecutive sub-scenarios, and the driving behavior information includes a decision made by the automatic driving system in each of the sub-scenarios and an execution result corresponding to the decision; the acquiring module 701 includes:
a first acquiring unit, configured to: for any driving scenario of the plurality of driving scenarios, input scenario information of an i-th sub-scenario into the automatic driving system, to acquire an i-th decision outputted by the automatic driving system according to the scenario information of the i-th sub-scenario;
an execution unit, configured to simulate execution of the i-th decision to obtain an execution result of the i-th decision;
an updating unit, configured to update the scenario information of the i-th sub-scenario according to the execution result of the i-th decision, to obtain scenario information of an (i+1)-th sub-scenario;
where i takes 1, 2, ..., N in sequence, and N is an integer greater than 1.

In a possible implementation manner, the updating unit includes:
a third determining subunit, configured to determine a target obstacle in the i-th sub-scenario and a motion parameter of the target obstacle;
an updating subunit, configured to update the scenario information of the i-th sub-scenario according to the execution result of the i-th decision and the motion parameter of the target obstacle, to obtain the scenario information of the (i+1)-th sub-scenario.

In a possible implementation, i is 1, and the acquiring module 701 further includes: a second acquiring unit; the second acquiring unit is configured to:
acquire sensing data of a first sub-scenario;
perform perceptual processing on the sensing data to obtain scenario information of the first sub-scenario.

In a possible implementation, the automatic driving system includes a perception unit and a planning and decision-making unit; the first acquiring unit is specifically configured to:
input the scenario information of the i-th sub-scenario into the planning and decision-making unit of the automatic driving system.

In a possible implementation, the second acquiring unit is specifically configured to:
generate sensing data of the first sub-scenario by simulation; or,
acquire sensing data collected by a vehicle in the first sub-scenario on a real road.

In a possible implementation, the automatic driving feature includes at least one of the following: a radicalness degree of a decision, a success rate of decision execution, and similarity between a decision execution process and a manual driving process.

The apparatus for determining an automatic driving feature provided in this embodiment can be used to execute the technical solution of any of the foregoing method embodiments, and the implementation principles and technical effects thereof are similar, which will not be repeated here.

According to embodiments of the present application, the present application also provides an electronic device and a readable storage medium.

According to an embodiment of the present application, the present application also provides a computer program product, and the computer program product includes: a computer program, which is stored in a readable storage medium. At least one processor of an electronic device can read the computer program from the readable storage medium, and the at least one processor executes the computer program to cause the electronic device to execute the method according to any of the foregoing embodiments.

FIG. 8 shows a schematic block diagram of an example electronic device that can be used to implement the embodiments of the present application. The electronic device is intended to represent various forms of digital computers, such as a laptop computer, a desktop computer, a workbench, a personal digital assistant, a server, a blade server, a mainframe computer, and other suitable computers. The electronic device may also represent various forms of mobile apparatuses, such as a personal digital assistant, a cellular phone, a smart phone, a wearable device, and other similar computing apparatuses. The components shown herein, their connections and relationships, and their functions are merely examples, and are not intended to limit the implementation of the present application described and/or claimed herein.

As shown in FIG. 8, the electronic device 800 includes a computing unit 801, which can execute various suitable actions and processing according to computer programs stored in a read-only memory (ROM) 802 or computer programs loaded into a random access memory (RAM) 803 from a storage unit 808. In the RAM 803, various programs and data required for operations of the electronic device 800 can also be stored. The computing unit 801, the ROM 802, and the RAM 803 are connected to each other through a bus 804. An input/output (I/O) interface 805 is also connected to the bus 804.

Multiple components in the device 800 are connected to the I/O interface 805, including: an input unit 806, such as a keyboard, a mouse, etc.; an output unit 807, such as various types of displays, speakers, etc.; the storage unit 808, such as a magnetic disk, an optical disk, etc.; and a communication unit 809, such as a network card, a modem, a wireless communication transceiver, etc. The communication unit 809 allows the device 800 to exchange information/data with other devices through a computer network such as the Internet and/or various telecommunication networks.

The computing unit 801 may be various general-purpose and/or special-purpose processing components with processing and computing capabilities. Some examples of the computing unit 801 include, but are not limited to, a central processing unit (CPU), a graphics processing unit (GPU), various types of dedicated artificial intelligence (AI) computing chips, various types of computing units that run machine learning model algorithms, a digital signal processor (DSP), and any appropriate processor, controller, microcontroller, etc. The computing unit 801 executes the various methods and processing described above, for example, the method for determining an automatic driving feature. For example, in some embodiments, the method for determining an automatic driving feature may be implemented as a computer software program, which is tangibly contained in a machine-readable medium, such as the storage unit 808. In some embodiments, part or all of a computer program may be loaded and/or installed on the device 800 via the ROM 802 and/or the communication unit 809. When the computer program is loaded into the RAM 803 and executed by the computing unit 801, one or more steps of the method for determining an automatic driving feature described above can be executed. Alternatively, in other embodiments, the computing unit 801 may be configured to perform the method for determining an automatic driving feature in any other suitable manner (for example, by means of a firmware).

The various implementations of the systems and techniques described herein can be implemented in a digital electronic circuit system, an integrated circuit system, a field programmable gate array (FPGA), an application specific integrated circuit (ASIC), an application specific standard product (ASSP), a system-on-chip (SOC), a complex programmable logic device (CPLD), computer hardware, firmware, software, and/or combinations thereof. These various implementations may include: being implemented in one or more computer programs that can be executed and/or interpreted on a programmable system including at least one programmable processor. The programmable processor may be a special-purpose or general-purpose programmable processor, and can receive data and instructions from a storage system, at least one input apparatus and at least one output apparatus, and transmit data and instructions to the storage system, the at least one input apparatus and the at least one output apparatus.

The program code used to implement the method of the present application can be written in any combination of one or more programming languages. These program codes can be provided to a processor or controller of a general-purpose computer, a special-purpose computer, or other programmable data processing apparatuses, so that when the program codes are executed by the processor or controller, the functions/operations specified in the flowcharts and/or block diagrams are implemented. The program codes can be executed entirely on a machine, partly on a machine, partly on a machine and partly on a remote machine as an independent software package, or entirely on a remote machine or server.

In the context of the present application, a machine-readable medium may be a tangible medium, which may include or store a program for use by the instruction execution system, apparatus or device, or for use in combination with the instruction execution system, apparatus or device. The machine-readable medium may be a machine-readable signal medium or a machine-readable storage medium. The machine-readable medium may include, but is not limited to, an electronic, magnetic, optical, electromagnetic, infrared or semiconductor system, apparatus or device, or any suitable combination thereof. More specific examples of the machine-readable storage medium may include electrical connections based on one or more wires, a portable computer disk, a hard disk, a random access memory (RAM), a read-only memory (ROM), an erasable programmable read-only memory (EPROM or flash memory), an optical fiber, a portable compact disk read-only memory (CD-ROM), an optical storage device, a magnetic storage device, or any suitable combination thereof.

To provide interaction with users, the systems and techniques described herein can be implemented on a computer which has: a display device (e.g., a CRT (cathode ray tube) or LCD (liquid crystal display) monitor) for displaying information to users; as well as a keyboard and a pointing apparatus (e.g., a mouse or a trackball) through which users can provide inputs to the computer. Other kinds of apparatuses can also be used to provide interaction with users, for example, a feedback provided to a user can be any form of sensory feedback (e.g., visual feedback, auditory feedback, or tactile feedback); and can receive inputs from users in any form (including acoustic input, voice input or tactile input).

The systems and techniques described herein can be implemented in a computing system including background components (e.g., as a data server), or a computing system including middleware components (e.g., an application server), or a computing system including front-end components (e.g., a user computer with a graphical user interface or a web browser through which users can interact with implementations of the systems and techniques described herein), or a computing system including any combination of such background components, middleware components or front-end components. Components of the system can be connected to each other through digital data communication in any form or medium (e.g., a communication network). Examples of the communication network include: a local area network (LAN), a wide area network (WAN), and the Internet.

A computer system may include a client and a server. The client and server are generally remote from each other and usually interact through a communication network. A relationship between the client and the server is generated by computer programs running on corresponding computers and having a client-server relationship with each other. The server may be a cloud server, also known as a cloud computing server or a cloud host, which is a host product in a cloud computing service system to solve the shortcomings of difficult management and weak business scalability in a traditional physical host and VPS service (Virtual Private Server, or VPS for short). The server may also be a server of a distributed system, or a server combined with a blockchain.

It should be understood that steps can be reordered, added or deleted for the various forms of processes shown above. For example, the steps described in the present application can be executed in parallel, sequentially or in a different order, so long as the desired result of the technical solutions disclosed in the present application can be achieved, which is not limited herein.

The above specific implementations do not constitute a limitation to the protection scope of the present application. It should be understood by those skilled in the art that various modifications, combinations, sub-combinations, and substitutions may be performed according to design requirements and other factors. Any modification, equivalent substitution, improvement and others that are made within the principle of the present application shall be included in the protection scope of the present application.

## Claims

1. A method for determining an automatic driving feature, **characterized by** comprising:
acquiring (S301, S401) scenario information of a plurality of driving scenarios and driving behavior information of an automatic driving system in each of the driving scenarios, wherein the driving behavior information comprises a decision made by the automatic driving system and an execution result corresponding to the decision;
determining (S302) an automatic driving feature of the automatic driving system according to the scenario information of the plurality of driving scenarios and respective driving behavior information, wherein the automatic driving feature is used for a map to provide decision pre-judgment information for the automatic driving system.

2. The method according to claim 1, wherein determining (S302) the automatic driving feature of the automatic driving system according to the scenario information of the plurality of driving scenarios and the respective driving behavior information comprises:
for any driving scenario of the plurality of driving scenarios, determining (S402) an automatic driving feature of the automatic driving system under the driving scenario according to the scenario information of the driving scenario and the corresponding driving behavior information;
determining (S403) the automatic driving feature of the automatic driving system according to automatic driving features of the automatic driving system under the plurality of driving scenarios.

3. The method according to claim 2, wherein determining (S402) the automatic driving feature of the automatic driving system under the driving scenario according to the scenario information of the driving scenario and the corresponding driving behavior information comprises:
acquiring, according to the scenario information of the driving scenario, host vehicle state information when the automatic driving system makes the decision, wherein the host vehicle state information comprises at least one of the following: a speed of a host vehicle, a distance between the host vehicle and an obstacle, a relative speed between the host vehicle and the obstacle;
determining the automatic driving feature of the automatic driving system under the driving scenario according to the host vehicle state information and the driving behavior information.

4. The method according to claim 2, wherein determining (S403) the automatic driving feature of the automatic driving system according to the automatic driving features of the automatic driving system under the plurality of driving scenarios comprises:
acquiring weights corresponding to the plurality of driving scenarios;
performing a weighting calculation on the automatic driving features under the plurality of driving scenarios according to the weights corresponding to the plurality of driving scenarios, to determine the automatic driving feature of the automatic driving system.

5. The method according to any one of claims 1 to 4, wherein each of the driving scenarios comprises a plurality of consecutive sub-scenarios, and the driving behavior information comprises a decision made by the automatic driving system in each of the sub-scenarios and an execution result corresponding to the decision;
for any driving scenario of the plurality of driving scenarios, acquiring the scenario information of the driving scenario and the driving behavior information of the automatic driving system in the driving scenario comprises:
inputting scenario information of an i-th sub-scenario into the automatic driving system, to acquire an i-th decision outputted by the automatic driving system according to the scenario information of the i-th sub-scenario;
simulating execution of the i-th decision to obtain an execution result of the i-th decision;
updating the scenario information of the i-th sub-scenario according to the execution result of the i-th decision, to obtain scenario information of an (i+1)-th sub-scenario;
wherein i takes 1, 2, ..., N in sequence, and N is an integer greater than 1.

6. The method according to claim 5, wherein updating the scenario information of the i-th sub-scenario according to the execution result of the i-th decision, to obtain the scenario information of the (i+1)-th sub-scenario comprises:
determining a target obstacle in the i-th sub-scenario and a motion parameter of the target obstacle;
updating the scenario information of the i-th sub-scenario according to the execution result of the i-th decision and the motion parameter of the target obstacle, to obtain the scenario information of the (i+1)-th sub-scenario.

7. The method according to claim 5, wherein i is 1, and the method further comprises:
acquiring sensing data of a first sub-scenario;
performing perceptual processing on the sensing data to obtain scenario information of the first sub-scenario.

8. The method according to claim 7, wherein the automatic driving system comprises a perception unit and a planning and decision-making unit; inputting the scenario information of the i-th sub-scenario into the automatic driving system comprises:
inputting the scenario information of the i-th sub-scenario into the planning and decision-making unit of the automatic driving system.

9. The method according to claim 7, wherein acquiring the sensing data of the first sub-scenario comprises:
generating sensing data of the first sub-scenario by simulation; or,
acquiring sensing data collected by a vehicle in the first sub-scenario on a real road.

10. The method according to any one of claims 1 to 4, wherein the automatic driving feature comprises at least one of the following: a radicalness degree of a decision, a success rate of decision execution, and similarity between a decision execution process and a manual driving process.

11. An apparatus for determining an automatic driving feature, **characterized by** comprising:
an acquiring module (701), configured to acquire scenario information of a plurality of driving scenarios and driving behavior information of an automatic driving system in each of the driving scenarios, wherein the driving behavior information comprises a decision made by the automatic driving system and an execution result corresponding to the decision;
a determining module (702), configured to determine an automatic driving feature of the automatic driving system according to the scenario information of the plurality of driving scenarios and respective driving behavior information, wherein the automatic driving feature is used for a map to provide decision pre-judgment information for the automatic driving system.

12. The apparatus according to claim 11, wherein the determining module (702) comprises:
a first determining unit, configured to: for any driving scenario of the plurality of driving scenarios, determine an automatic driving feature of the automatic driving system under the driving scenario according to the scenario information of the driving scenario and the corresponding driving behavior information;
a second determining unit, configured to determine the automatic driving feature of the automatic driving system according to automatic driving features of the automatic driving system under the plurality of driving scenarios.

13. An electronic device, comprising:
at least one processor; and
a memory communicatively connected to the at least one processor; wherein,
the memory stores instructions executable by the at least one processor, and the instructions are executed by the at least one processor to enable the at least one processor to execute the method according to any one of claims 1 to 10.

14. A non-transitory computer-readable storage medium, having computer instructions stored thereon, wherein the computer instructions are used to cause the computer to execute the method according to any one of claims 1 to 10.

15. A computer program product, comprising a computer program that, when executed by a processor, implements the method according to any one of claims 1 to 10.
